# EUROPÄISCHE PATENTSCHRIFT

(11) **EP 0 703 639 B1**
(45) Veröffentlichungstag und Bekanntmachung des Hinweises auf die Patenterteilung: **01.04.1998**
(21) Anmeldenummer: 94114867.8
(22) Anmeldetag: 21.09.1994
(51) Int. Cl.: H01R 9/09

(54) **Schichtschaltung mit Anschlussklemmen**
Multilayer electric circuit with connecting terminals
Circuit électrique multicouche avec des bornes de raccordement

(43) Veröffentlichungstag der Anmeldung: 27.03.1996
(73) Patentinhaber: SIEMENS AKTIENGESELLSCHAFT, 80333 München (DE)
(72) Erfinder: Drekmeier, Karl Gerd, D-82008 Unterhaching (DE)

(56) Entgegenhaltungen:
- EP-A- 0 148 461
- EP-A- 0 388 478
- DE-A- 2 345 046
- DE-A- 2 806 683
- US-A- 4 469 389
- US-A- 4 712 850

## Beschreibung

Die Erfindung betrifft eine Schichtschaltung mit wenigstens einer Reihe Anschlußklemmen zur Verbindung mit metallisierten Löchern einer Leiterplatte, wobei die Anschlußklemmen auf der einen Seite über eine taschenförmige Klemmkontur mit Anschlußflächen der Schichtschaltung verbunden sind und auf der anderen Seite zur Verbindung mit der Leiterplatte im Anschluß an eine Verbreiterung ein bandförmiges vergleichsweise schmaleres Anschlußstück aufweisen, bei der zur Steckkontaktierung in den Löchern der Leiterplatte wenigstens eines der Anschlußstücke unter Bildung einer Feder mit einem freien und einem mit der Verbreiterung verbundenen Schenkel V-förmig umgebogen ist, wobei der Biegeradius deutlich kleiner als der Durchmesser des entsprechenden Leiterplattenloches ist.

Eine derartige Schichtschaltung ist aus der EP-0 148 461 B1 bekannt.

Schichtschaltungen in single- oder dual-in-line Bauform haben Anschlüsse, deren Querschnitt bis Faktor 10 kleiner ist, als die Kreisfläche der Montagelöcher in Leiterplatten oder ähnlichen Schaltungsträgern. Die bekannten, V-förmig gebogenen Anschlußklemmen überbrücken federnd diese Querschnittsdifferenz, so daß eine gewisse Standhilfe gegeben ist. Probleme treten jedoch insofern auf, als die bekannte Standhilfe einen gerundeten Biegebereich, also ein gerundetes Anschlußende, aufweist. Dadurch entsteht zwar wie vorgesehen ein Anschlußende mit vorteilhaft kleinem Einführungsquerschnitt für die Leiterplattenlöcher. Allerdings ist die Einführbarkeit in sehr kleine Löcher mit einem Durchmesser von weniger als 1,0mm nicht mehr in idealer Weise gegeben. Vor allem jedoch erfordert das Einstecken der bekannten Standhilfe in derartig kleine Löcher konstruktionsbedingt unerwünscht hohe Steckkräfte, so daß der Einsatz der Standhilfe dort bisher nicht empfehlenswert war.

Ein weiteres Problem tritt bei eine Pinzahl( Zahl der V-förmig gebogenen Anschlußklemmen )von weniger als 5 auf, da die gesteckten Schaltungen dann beim Transport ausgetrieben werden können. Es wurde zwar versucht, durch Erweitern der V-Öffnung die Haltekraft zu erhöhen, jedoch ohne vollständigen Erfolg.

Der vorliegenden Erfindung liegt daher die Aufgabe zugrunde, eine verbesserte Schichtschaltung der eingangs angegebenen Art zu schaffen.

Erfindungsgemaß wird diese Aufgabe dadurch gelöst, daß die Materialdicke der umgebogenen Anschlußstücke im Biegebereich um etwa 50% reduziert ist.

Weiterbildungen der Erfindung sind Gegenstand von Unteransprüchen.

Im folgenden wird die Erfindung anhand der in den Figuren der Zeichnung dargestellten Ausführungsbeispiele noch näher erläutert. Es zeigt:
- Figur 1: eine Schichtschaltung mit einer Anschlußklemme in Seitenansicht,
- Figur 2: in gleicher Ansicht die Anschlußklemme gemäß Figur 1, eingesteckt in ein Kontaktloch, ungelötet,
- Figur 3: die Ausführung nach Figur 2, eingesteckt in einem engeren Kontaktloch,
- Figur 4: die Ausführung nach Figur 3 eingesteckt in einem mit einem Kontakteinsatz versehenen Kontaktloch,
- Figur 5: in Seitenansicht eine Schichtschaltung mit zwei Reihen Anschlußklemmen.

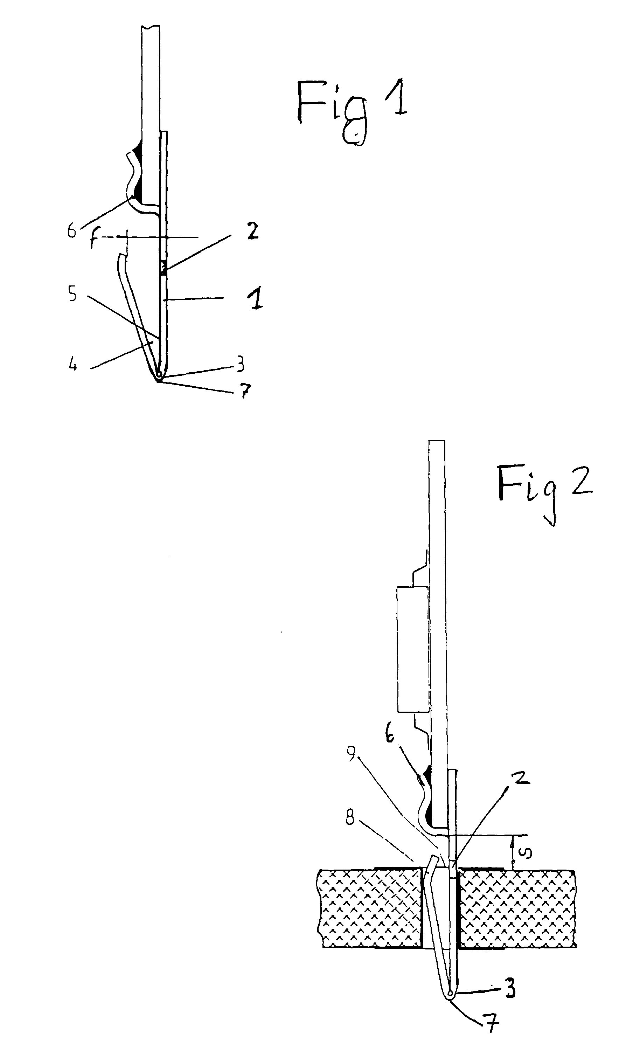

In Figur 1 ist eine in eine zur Anschlußklemme gehörige Klemmkontur 6 eingelötete Schichtschaltung dargestellt. Erkennbar ist die Materialverdünnung im Biegebereich 3 gegenüber der Querschnittsdicke 2 des übrigen Anschlußstückes 1 mit V-Form 4. Bei einer Zinnschichtdicke 5 von mehr als 10µm, die beim Tauchlöten der Klemmkonturen 6 bzw. Anschlußclips an die Schichtschaltung im Bereich der Anschlußpins entsteht, ist durch den veränderten Querschnitt ein innerer Biegeradius von weniger als O,lmm möglich. Dadurch entsteht ein so kleiner, spitz zulaufender Außenradius 7, so daß eine gewünschte Einführhilfe und eine geringe Steckkraft bei Leiterplattenlöchern mit einem Durchmesser von weniger als 1,0mm gegeben ist.

Wie Figur 2 zeigt, sind die Anschlüsse bis zum "stand off" (s) in die durchkontaktierten z. B. einen Durchschnitt von 0,9mm aufweisenden Leiterplattenlöcher gesteckt. Der ballig nach innen ausgeformte Endbereich 8 des freien Federschenkels liegt definiert unterhalb der Lochkante 9 an und verhindert somit die sonst störende Austriebskraft. In dieser Position kann transportiert und schwallgelötet werden, ohne daß die Schaltung ihre Lage zur Leiterplatte verändert.

Der in Figur 1 angedeutete Verformungsweg f der Feder kann im elastischen Werkstoffbereich liegen. Somit ist ein Mehrfachstecken unter den geforderten Kriterien möglich.

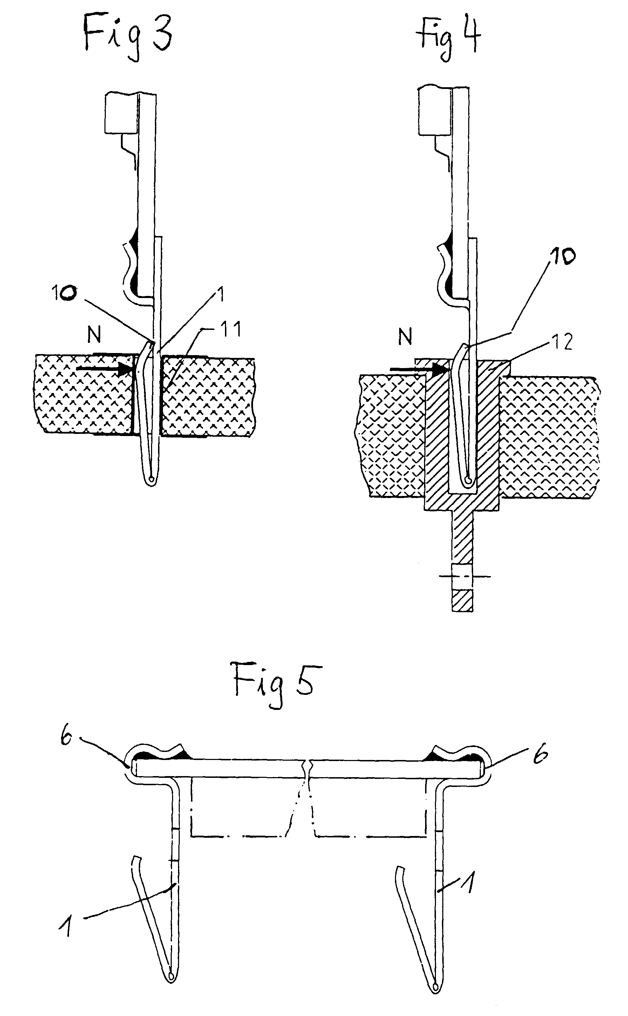

Diese Tatsache erlaubt eine mehrmalige elektrisch Kontaktierung zwischen dem Anschlußstück 1 und der Leiterplatten-Durchkontaktierung 11 oder einem Kontakteinsatz 12, wie die Figuren 3 und 4 beispielhaft zeigen. Die notwendige Kontaktkraft N wird durch die Abstützung 10 um ca. Faktor 10 erhöht. Die so ausreichend kontaktierte Schaltung kann beispielsweise aus Stabilitätsgründen nachträglich ohne Positionsänderung eingelötet werden.

Figur 5 zeigt die mögliche Anwendung dieser Erfindung bei dual-in-line-Schaltungen zwecks Kontaktierung wie bei den Figuren 3 und 4 oder zur Halterung beim Transport und Löten in Leiterplatten.

## Patentansprüche

1. Schichtschaltung mit wenigstens einer Reihe Anschlußklemmen zur Verbindung mit metallisierten Löchern einer Leiterplatte, wobei die Anschlußklemmen auf der einen Seite über eine taschenförmige Klemmkontur (6) mit Anschlußflächen der Schichtschaltung verbunden sind und auf der anderen Seite zur Verbindung mit der Leiterplatte im Anschluß an eine Verbreiterung ein bandförmiges vergleichsweise schmaleres Anschlußstück (1) aufweisen, bei der zur Steckkontaktierung in den Löchern der Leiterplatte wenigstens eines der Anschlußstücke (1) unter Bildung einer Feder mit einem freien und einem mit der Verbreiterung verbundenen Schenkel V-förmig umgebogen ist, wobei der Biegeradius deutlich kleiner als der Durchmesser des entsprechenden Leiterplattenloches ist,
**dadurch gekennzeichnet,**
daß die Materialdicke der umgebogenen Anschlußstücke (1) im Biegebereich (3) um etwa 50% reduziert ist.

2. Schichtschaltung nach Anspruch 1, bei der das Anschlußstück (1) mit einem inneren Biegeradius von weniger als 0,lmm und einem entsprechend kleinen, spitz zulaufenden Außenradius (7) ausgebildet ist.

3. Schichtschaltung nach Anspruch 1 oder 2, bei der der Endbereich (8) des freien Schenkels ballig mit nach innen zum anderen Schenkel weisendem Schenkelende ausgebildet ist.

4. Schichtschaltung nach Anspruch 3, bei der der Endbereich (8) ballig so weit nach innen gebogen ist, daß das Schenkelende am anderen Schenkel abgestützt ist.

## Claims

1. Film circuit with at least one row of supply terminals for connecting to plated-through holes of a printed circuit board, the supply terminals being connected at one end via a pocket-shaped clamping contour (6) to terminal faces of the film circuit and, for the purpose of connection to the printed circuit board, having at the other end following an extension a strip-shaped, comparatively narrow terminal fitting (1), in which circuit, for the purpose of plug-in contacting in the holes of the printed circuit board, at least one of the terminal fittings (1) is bent over in the shape of a V to form a spring having one free limb and a limb connected to the extension, the bending radius being substantially smaller than the diameter of the corresponding printed circuit board hole, characterized in that the material thickness of the bent-over terminal fitting (1) is reduced in the bending region (3) by approximately 50%.

2. Film circuit according to Claim 1, in which the terminal fitting (1) is constructed with an inside bending radius of less than 0.1 mm and a correspondingly small outside radius (7) tapering to a point.

3. Film circuit according to Claim 1 or 2, in which the end region (8) of the free limb is constructed convexly with the limb end pointing inwards towards the other limb.

4. Film circuit according Claim 3, in which the end region (8) is bent convexly inwards so far that the limb end is supported on the other limb.

## Revendications

1. Circuit électrique multicouche avec au moins une rangée de bornes de raccordement servant à la liaison avec des trous métallisés d'un circuit imprimé, les bornes de raccordement étant reliées à des surfaces de connexion du circuit électrique multicouche, sur un côté, par le biais d'un contour de borne (6) en forme de poche et étant pourvues, sur l'autre côté, en vue de la liaison avec le circuit imprimé, succédant à un élargissement, d'un élément de raccordement (1) relativement plus étroit en forme de bande, et où, en vue de la mise en contact par enfichage dans les trous du circuit imprimé, au moins un des éléments de raccordement (1) est plié en forme de V de manière à former un ressort avec une branche libre et une branche reliée à l'élargissement, le rayon de courbure étant nettement plus petit que le diamètre du trou correspondant du circuit imprimé, caractérisé en ce que l'épaisseur de matériau des éléments de raccordement (1) pliés est réduite d'à peu près 50% dans la zone de pliage (3).

2. Circuit électrique multicouche selon la revendication 1, dans lequel l'élément de raccordement (1) est exécuté avec un rayon de courbure interne inférieur à 0,1 mm et un rayon externe (7) se terminant en pointe et qui est, en conséquence, petit.

3. Circuit électrique multicouche selon la revendication 1 ou 2, dans lequel la zone d'extrémité (8) de la branche libre est exécutée de manière bombée avec une extrémité de branche dirigée à l'intérieur vers l'autre branche.

4. Circuit électrique multicouche selon la revendication 3, dans lequel la zone d'extrémité (8) est bombée à un tel point vers l'intérieur que l'extrémité de la branche est appuyée sur l'autre branche.
